# EUROPEAN PATENT SPECIFICATION

(11) **EP 4 583 139 B1**
(45) Date of publication and mention of the grant of the patent: **04.11.2026**
(21) Application number: 24307332.7
(22) Date of filing: 30.12.2024
(51) Int. Cl.: H01H 47/32

(54) **CONTACTOR**
KONTAKTOR
CONTACTEUR

(30) Priority: 08.01.2024 CN 202420047682 U
(43) Date of publication of application: 09.07.2025
(73) Proprietor: Schneider Electric Industries SAS, 92500 Rueil-Malmaison (FR)
(72) Inventor: FENG, Siyang, Shanghai, 201203 (CN); GEFFROY, Vincent, Shanghai, 201203 (CN); XIE, Juan, Shanghai, 201203 (CN); ZHUANG, Hao, Shanghai, 201203 (CN); YAN, Songxue, Shanghai, 201203 (CN); XU, Jungang, Shanghai, 201203 (CN)
(74) Representative: Manitz Finsterwald Patent- und Rechtsanwaltspartnerschaft mbB

(56) References cited:
- CN-A- 116 453 905
- GB-A- 2 273 836
- US-A1- 2007 223 172
- US-B2- 11 843 380

## Description

### Technical field

The disclosure relates to a contactor.

### Background

Contactors are used to turn on or off AC or DC circuits with loads over long distances and at frequent intervals, and are mainly used to control electric loads such as motors and transformers. Inside the contactor, the control circuit controls the electromagnetic system to generate a magnetic field, which in turn controls the switching on and off of the contactor contacts.

Contactors can be categorized into mechanical and electronic contactors. In mechanical contactors there are usually several coils arranged to cope with different voltage levels. In electronic contactors, the current in the coils can be adjusted to actively adapt to different voltage levels. In electronic contactors, in order to supply power to control circuits, such as a control chip, an IGBT (Insulated Gate Bipolar Transistor) buck chopper circuit or a flyback buck circuit can be used to reduce the high voltage on the line to a low voltage available to the control circuits and the chip. However, in the case of high line voltages, such as above 400V, a direct bucking with IGBT results in excessive power consumption of the IGBTs, which requires the addition of an auxiliary heat sink. In the case where a Flyback buck circuit is used, although large power consumption would not be generated, the Flyback buck circuit is costly and takes up a large amount of space. For this reason, it is necessary to develop a new type of power supply circuit suitable for contactors.

US 11 843 380 B2 discloses a contactor and a control device. The control device comprises a high-side control unit, a first low-side control unit, and a second low-side control unit, which are configured to control the connection between the power supply and two magnetic units of the contactor. The high-side control unit is arranged to switch the connection between the power supply and the magnetic units, while the first and second low-side control units independently switch the connection between each magnetic unit and a reference voltage node. The system further includes a flyback unit connected across the branch formed by the first magnetic unit and its corresponding low-side switch, as well as across the branch formed by the second magnetic unit and its respective low-side switch, allowing for recirculation of inductive current during turn-off. A controller is provided to control the operation of the high-side and low-side control units, enabling intelligent switching behavior of the contactor. The control method allows for flexible and reliable operation using relatively simple control logic.

GB 2 273 836 A discloses a switch-mode control system for an injector, in which a high-voltage power supply and a low-voltage power supply are selectively used to control the current in an injector coil. The system includes a recirculation circuit with a switch and a diode, and current is regulated by switching between the charge and recirculation paths based on feedback from a current sensor. The high-voltage supply enables fast current rise at the start of injection, while the low-voltage supply maintains the current efficiently.

### Summary

The disclosure provides a contactor. The contactor according to the disclosure can be applied to a large voltage range and a high input voltage, and can convert the large input voltage into a small output voltage for powering control circuits and chips in the contactor. The contactor according to the disclosure has a low power consumption and a small size.
The disclosure provides a contactor, the contactor comprising: a coil unit comprising a coil and a first switch, wherein a first end of the first switch is connected to an input and a second end of the first switch is connected to the coil; a first power supply unit comprising a second switch and a voltage stabilizing diode, wherein the second switch is connected in parallel with the voltage stabilizing diode, and the first power supply unit is connected in series with the coil unit, wherein a cathode of the voltage stabilizing diode is connected to the output of the first power supply unit; a current detection unit, which is configured to detect a current flowing through the coil and to feed a current detection signal to a control unit; a voltage detection unit, which is configured to detect a first supply voltage at the output and to feed a voltage detection signal to the control unit; and the control unit, which is configured to control the switching on and off of the first switch according to the current detection signal, and to control the switching on and off of the second switch according to the voltage detection signal, wherein the first supply voltage is less than an input voltage at the input. The control unit is configured to control the duty cycle of the first switch and the duty cycle of the second switch by means of pulse width modulation.

In an embodiment according to the disclosure, the contactor further comprises: a freewheeling diode, the freewheeling diode being connected in parallel with a series circuit comprising the coil and the first power supply unit.

In an embodiment according to the disclosure, the first power supply unit further comprises a transient voltage suppressor, a first end of the transient voltage suppressor being connected to an output of the first power supply unit, and a second end of the transient voltage suppressor being connected between the coil and the first power supply unit.

In an embodiment according to the disclosure, the contactor further comprises: a second power supply unit, which is configured to convert the input voltage to a second supply voltage; wherein the second supply voltage is output by the second power supply unit in response to the input voltage being less than a voltage threshold, and the first supply voltage is output by the first power supply unit in response to the input voltage being greater than the voltage threshold.

In an embodiment according to the disclosure, the voltage threshold is 400V.

In an embodiment according to the present disclosure, the first switch and/or the second switch are constructed as insulated gate bipolar transistors.

In an embodiment according to the disclosure, the current detection unit comprises a sampling resistor and a filter circuit connected in parallel with the sampling resistor.

In an embodiment according to the disclosure, the contactor further comprises: a rectifier module for converting the alternating current at the input to direct current.

In an embodiment according to the disclosure, the first supply voltage is 15V.

The contactor according to the disclosure can be applied to different voltage ranges, and even in the case of large input voltages, the contactor according to the disclosure can safely, reliably and with low power consumption convert large input voltages into small voltages usable by the chip or the microcircuit, and the contactor according to the disclosure can also reduce the power consumption and the heat generation of the switching devices such as IGBTs, and thus ensure the safety of the switching devices. safety of the switching device. In addition, the contactor according to the present disclosure has a simple circuit structure, has a smaller number of devices, and has a smaller size.

### Brief description of drawings

In order to more clearly illustrate the technical solutions of the embodiments of the disclosure, the accompanying drawings to be used in the description of the embodiments will be briefly described below. Obviously, the accompanying drawings in the following description are only some exemplary embodiments of the disclosure, and other embodiments can be obtained according to these embodiments for those of ordinary skill in the art without creative labor.
Fig. 1 illustrates a schematic circuit diagram of a contactor according to an embodiment of the disclosure,
Fig. 2 illustrates a schematic circuit diagram of a contactor according to another embodiment of the disclosure,
Fig. 3 illustrates a schematic circuit diagram of a contactor according to another embodiment of the present disclosure, and
Fig. 4 illustrates a schematic circuit diagram of a contactor according to another embodiment of the disclosure.

### Detailed description

In this specification and the accompanying drawings, substantially the same or similar steps and elements are indicated by the same or similar drawing marks, and repetitive descriptions of these steps and elements will be omitted. Also, in the description of the disclosure, the terms "first", "second", etc. are used only to differentiate the description and are not to be understood as indicating or implying relative importance or ordering.

Contactors are usually installed on low-voltage circuits, low-voltage being the voltage range of a few hundred volts to ten kilovolts. In order to power the control circuits or chips in the contactor, it is often necessary to convert the low voltage to a microvoltage of, e.g., around 15 V. This is done by using IGBTs (Insulated Gate Bipolar Transistors) with high power ratings. For this purpose, it is often necessary to step down the voltage using a large power rating IGBT (Insulated Gate Bipolar Transistor) with additional heat sinks. However, such structures are expensive, take up a lot of space, and are limited by isolation.

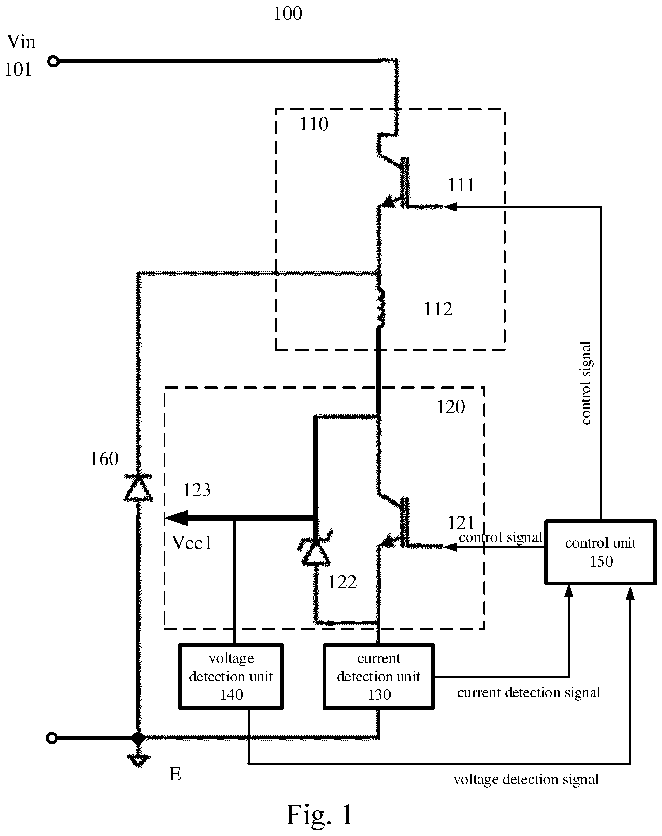

The present disclosure proposes a scheme for generating microvoltages based on a coil of a contactor. Fig. 1 illustrates a schematic circuit diagram of a contactor 100 according to an embodiment of the disclosure. The contactor 100 can convert a larger input voltage of several hundred volts to a smaller supply voltage of, e.g., 15V in order to power control circuits and chips in the contactor 100.

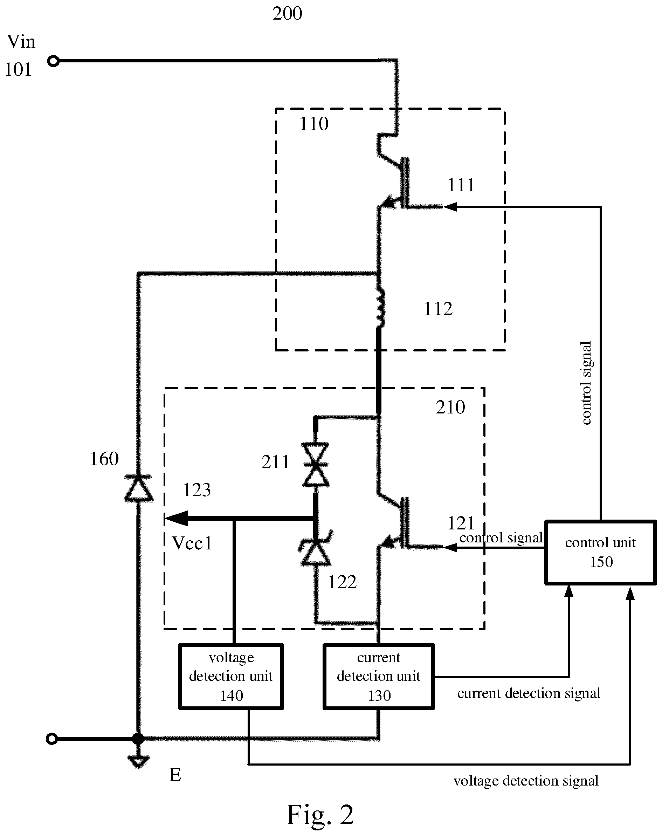

In Fig. 1, the input 101 of the contactor 100 is configured to connect to an external low voltage line. In an embodiment according to the disclosure, the voltage on the external low-voltage line, i.e. the input voltage Vin of the input 101, can in particular be in the range of 200V to 500V. It should be noted that the voltage referred to in the present disclosure is the voltage with respect to the ground E. The contactor 100 comprises a coil unit 110, a first power supply unit 120, a current detection unit 130, a voltage detection unit 140 and a control unit 150. The coil unit 110 comprises a coil 112 and a first switch 111. A first end of the first switch 111 is connected to the input 101. The second end of the first switch 111 is connected to the coil 112. As shown in Fig. 2, the first switch 111 is constructed, e.g., as an IGBT. a collector of the first switch 111 constructed as an IGBT is connected to the input 101, and an emitter of the first switch 111 constructed as an IGBT is connected to the coil 112. The first power supply unit 120 is connected in series with the coil unit 110. The first power supply unit 120 comprises a second switch 121 and a voltage stabilizing diode 122. The second switch 121 is connected in parallel with the voltage stabilizing diode 122. As shown in Fig. 2, the second switch 111 is also constructed, e.g., as an IGBT. a collector of the second switch 121 constructed as an IGBT is connected to a cathode of the voltage stabilizing diode 122, and an emitter of the second switch 121 constructed as an IGBT is connected to an anode of the voltage stabilizing diode 122. The cathode of the voltage stabilizing diode 122 is connected to an output 123 of the first power supply unit 120. An output first supply voltage Vcc1 is output at the output 123. The first supply voltage Vcc1 is less than an input voltage Vin, and the first supply voltage Vcc1 can be, e.g., 15 V. In an embodiment according to the present disclosure, the first switch 111 and/or the second switch 121 can be constructed as a MOSFET (Metal Oxide Semiconductor Field Effect Transistor) or other power electronic switches.

The current detection unit 130 is configured to detect the current flowing through the coil 112 and to feed the current detection signal to the control unit 150. In Fig. 1, the current detection unit 130 is arranged below the first power supply unit 120 and is connected in series with the first power supply unit 120. The control unit 150 controls the switching on and off of the first switch 111 according to the current detection signal and the switching on and off of the second switch 121 according to the voltage detection signal. The control unit 150 controls the switching on and off of the first switch 111 to adjust the amount of current flowing through the coil 112. The magnitude of the current flowing through the coil 112 affects the magnitude of the magnetic field formed in the coil and, consequently, the suction to the contacts of the contactor 100. In an embodiment according to the disclosure, the current detection unit 130 can comprise a sampling resistor. The control unit 150 can, e.g., determine the magnitude of the current flowing through the coil 112 based on the voltage drop across the sampling circuit. In an embodiment according to the disclosure, the current detection unit 130 can also comprise a sampling resistor and an RC filter circuit connected in parallel with the sampling resistor. The RC filter circuit is capable of eliminating high-frequency noises, and the control unit 150 can thus determine the magnitude of the current flowing through the coil 112 more accurately.

The voltage detection unit 140 detects a first supply voltage Vcc1 at the output 123 and feeds the voltage detection signal to the control unit 150, which controls the switching on and off of the second switch 121 so as to convert a high input voltage Vin (e.g., in the range of 200V to 500V) at the input 101 to a low first supply voltage Vcc1 (e.g., 15V) at the output 123. The first supply voltage Vcc1 is fed to the control unit 150, other control circuits and other chips to provide electrical power. The first supply voltage Vcc1 can be fed directly or after a step-down process, depending on the magnitude of the voltage applicable to the control unit 150 or other chips.

According to the invention, the control unit 150 controls the duty cycle of the first switch 111 and the duty cycle of the second switch 112 with Pulse Width Modulation (PWM). The duty cycle represents a ratio of an on-time to a period of the switches, with one on-time and one off-time constituting a period. In an embodiment according to the disclosure, the control unit 150 can employ PI regulation or PID regulation, and adjust the magnitude of the duty cycle of the first switch 111 according to the acquired current acquisition signal, and adjust the magnitude of the duty cycle of the second switch 121 according to the acquired voltage acquisition signal.

In the coil unit 110, if the first switch 111 is switched on, the coil 112 is charged. If the first switch 111 is switched off, the coil 112 is discharged. Thus, the charging and discharging of the coil 112 can be adjusted by controlling the switching on and off of the first switch 111, and as a result, the amount of current flowing through the coil 112 can be adjusted.

In an embodiment according to the present disclosure, the contactor 100 can further comprise a freewheeling diode 160. The freewheeling diode 160 is connected in parallel with a series circuit comprising the coil 112 and the first power supply unit 120. When the first switch 111 is switched off and the coil 112 is discharged, the freewheeling diode 160 provides a circuit for the current. Assuming that the current flowing through the coil 112 has been adjusted to a suitable magnitude, if the second switch 121 is on, the current flows through the second switch 121 to reach the ground E, and the voltage (transient value) at the output 123 of the first power supply unit 120 is close to 0 V. If the second switch 121 is off, the current can only flow through the voltage stabilizing diode 122, which is connected in parallel with the second switch 121, to reach the ground E. The voltage stabilizing diode 122 can stabilize the voltage (transient value) at the output 123 to an adjusted value, e.g., 17 V. By adjusting the duty cycle of the second switch 121, the RMS value of the voltage, i.e., the first power supply voltage Vcc1, at the output 123 of the first power supply unit 120 can be maintained at the desired value of the voltage, e.g., maintained at 15 V.

In a specific control method, the second switch 121 is switched off, energy begins to be charged at the output 123, the voltage applied to the voltage stabilizing diode 122 gradually increases, and the voltage stabilizing diode 122 conducts in reverse and stabilizes the voltage to an adjusted value when the voltage exceeds a reverse conduction threshold of the voltage stabilizing diode 122. When there is too much energy on the voltage stabilizing diode 122 and the voltage stabilizing diode 122 is no longer capable of stabilizing the voltage and causes the voltage at the output 123 to be too high, the second switch 121 is switched on so that the current no longer flows through the voltage stabilizing diode 122. By adjusting the duty cycle of the second switch 121, the RMS value of the voltage at the output 123 of the first power supply unit 120, i.e., the first supply voltage Vcc1 is maintained at a desired voltage value, e.g. at 15V.

The contactors according to the disclosure can be applied to different voltage ranges, and even in the case of large input voltages, the contactors according to the disclosure can safely, reliably and with low power consumption convert large input voltages into smaller voltages usable by the control circuits or chips, and the contactors according to the disclosure can also reduce the power consumption and heat generation of the switching devices such as the IGBTs, thus ensuring the safety of the switching devices. In addition, the contactor according to the present disclosure has a simple circuit structure, has a smaller number of devices, and has a smaller size.

Fig. 2 shows a schematic circuit diagram of a contactor 200 according to another embodiment of the disclosure. The difference of the contactor 200 shown in Fig. 2 with respect to the contactor 100 shown in Fig. 1 is in the additional arrangement of a transient voltage suppressor 211. The transient voltage suppressor 211 is arranged in a first power supply unit 210. A first end of the transient voltage suppressor 211 is connected to the output 123, and a second end of the transient voltage suppressor 211 is connected between the coil 112 and the first power supply unit 210. In other words, in the embodiment shown in Fig. 2, the first end of the transient voltage suppressor 211 is connected to the output 123, and the second end of the transient voltage suppressor 211 is connected to a collector of the second switch 121 designed as an IGBT.

The actual voltage stabilizing diode 122 is not an ideal voltage stabilizing diode and, as a result, does not achieve ideal voltage stabilization, i.e., there can be fluctuations in the voltage drop of the voltage stabilizing diode 122 when the voltage stabilizing diode 122 conducts in reverse, due to the fact that the voltage stabilizing diode 122 does not consume more energy when the voltage applied to the voltage stabilizing diode 122 is too high. For this reason, a Transient Voltage Suppressor (TVS) is added in the embodiment according to the present disclosure. In an embodiment according to the present disclosure, the transient voltage suppressor 211 can stabilize the voltage (transient value) at its illustrated upper end (i.e., the voltage (transient value) between the coil 112 and the first power supply unit 210) to a specific value, e.g., 200 V. In the case that the second switch 121 is switched off, the voltage (transient value) at the upper end of the transient voltage suppressor 211 gradually increases until the transient voltage suppressor 211 conducts. The transient voltage suppressor 211 consumes energy in the circuit and always stabilizes the voltage (transient value) at the upper end of the transient voltage suppressor 211 at 200 V. This avoids excessive voltages and allows the voltage stabilizing diode 122 to always have the ability to stabilize the voltage (transient value) at the output 123 to the adjusted value.

By adding the transient voltage suppressor 211, the voltage stabilizing diode 122 can have a better voltage stabilization effect, i.e., the voltage stabilizing diode 122 can sufficiently stabilize the voltage (transient value) to the stabilized value without fluctuation. In the case where the second switch 121 is switched on, the voltage (transient value) at the output 123 is 0 or close to 0, and in the case where the second switch 121 is switched off, the voltage (transient value) at the output 123 is stabilized to the adjusted value. In this case, the control unit 150 can more easily adjust the amount of duty cycle of the second switch 121 by PI regulation or PID regulation, and stabilize the effective value of the output voltage at the output 123, i.e., the first power supply voltage Vcc1, to a desired value, e.g., 15 V. The addition of the transient voltage suppressor improves the accuracy of the regulation of the output voltage on the one hand, and on the other hand, the power consumption in the current is improved by the transient voltage suppressor. The addition of the transient voltage suppressor on the one hand improves the precision of regulating the output voltage, and on the other hand reduces the power consumption of the coil by consuming energy in the current through the transient voltage suppressor.

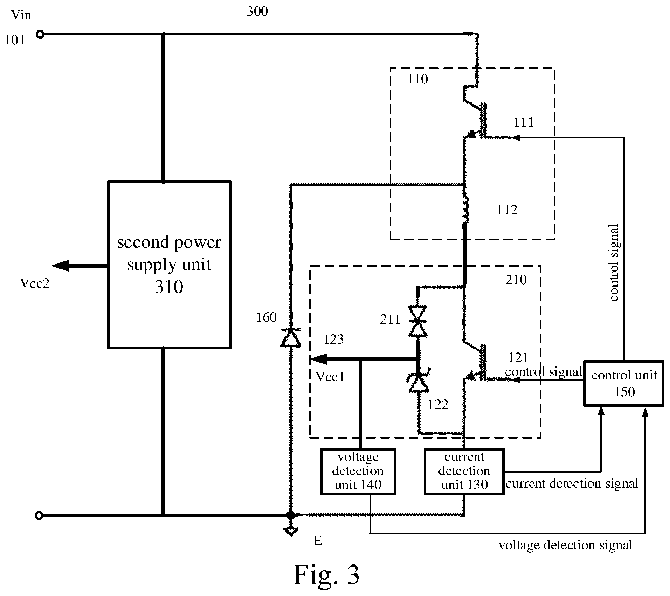

Fig. 3 shows a schematic circuit diagram of a contactor 300 according to another embodiment of the disclosure. The difference of the contactor 300 shown in Fig. 3 with respect to the contactor 200 shown in Fig. 2 is the additional second power supply unit 310. The second power supply unit 310 is likewise used to convert a large input voltage of the input 101 to a smaller voltage available to the control circuit or chip of the contactor. The output voltage of the second power supply unit 310 is a second supply voltage Vcc2. The second power supply unit 310 can be constructed as a buck converter including a switching device such as an IGBT. The second power supply unit 310 can be constructed as a buck circuit, a boost-buck buck circuit, or a flyback circuit. Alternatively, the second power supply unit 310 can be other types of buck circuits that have been applied in the prior art. In general, the second power supply unit 310 can be employed to power the control unit 150, other control circuits, and other chips in the contactor 300 in the case where the input voltage Vin at the input 101 is small. In an embodiment according to the disclosure, e.g., a voltage threshold can be set such that if the input voltage Vin of the input 101 is lower than the voltage threshold, a second power supply voltage Vcc2 is output by the second power supply unit 310, and if the input voltage Vin of the input 101 is higher than the voltage threshold, a first power supply voltage Vcc1 is output by the first power supply unit 210. In an embodiment according to the disclosure embodiment, the input voltage Vin of the input 101 can be, e.g., in the range of 200 V to 500 V, and the voltage threshold can be, e.g., set to 400 V. In the case where the second power supply unit 310 outputs the second power supply voltage Vcc2, the buck circuit in the second power supply unit 310 is activated and the switching devices therein are switched on and off while the second switch 121 in the first power supply unit 210 remains switched on. In the case where the first power supply voltage Vcc1 is output from the first power supply unit 210, the second switch 121 in the first power supply unit 210 is switched on and off under the control of the control unit 150, while the switching device in the second power supply unit 310 remains switched off.

The contactor 300 according to the disclosure is suitable for high input voltages and does not require auxiliary heat dissipation measures, and has the advantages of low power consumption and a small footprint.

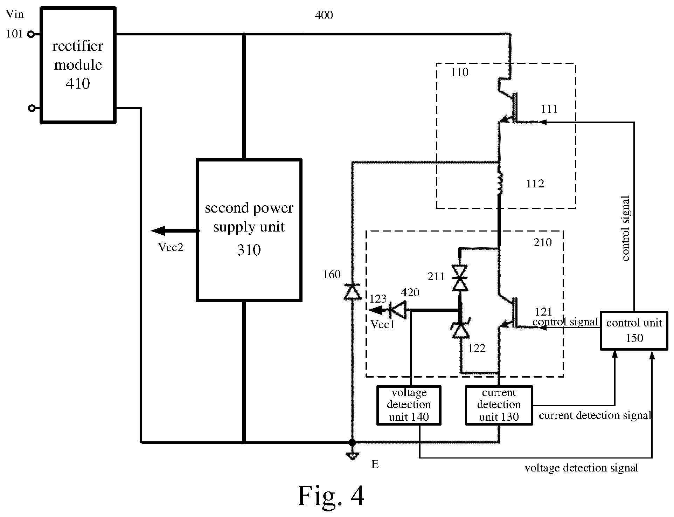

Fig. 4 illustrates a schematic circuit diagram of a contactor 400 according to another embodiment of the disclosure. The contactor 400 shown in Fig. 4 has a rectifier module 410 added at the input 101. The rectifier module 410 is configured to convert the incoming AC power to DC power. When the contactor 400 is applied in an AC line, the rectifier module 410 can convert the input AC power to DC power for a voltage reduction operation by the first power supply unit 210 or the second power supply unit 310 to reduce it to a low voltage, for example 15V, available for the control unit 150, other control circuits and other chips in the contactor 400.

The contactor 400 shown in Fig. 4 also adds an output diode 420 at the output 123 of the first power supply unit 210.The output diode 420 is configured to ensure the direction of the output current to prevent a reverse current from the control unit 150 to the first power supply unit 210.

The block diagrams of the circuits, units, devices, apparatuses, equipment, and systems involved in the present disclosure are intended to be exemplary only and do not purport to require or imply that they must be connected, arranged, or configured in the manner illustrated in the block diagrams. As those skilled in the art will recognize, the circuits, units, devices, apparatuses, equipment, and systems can be connected, arranged, and configured in any manner as long as they are capable of achieving the desired purpose. The circuits, units, devices, appliances involved in the present disclosure can be implemented in any suitable manner, e.g., by using special purpose integrated circuits, field programmable gate arrays (FPGAs), etc., or by using a general purpose processor in combination with a program.

## Claims

1. A contactor (100), comprising:
a coil unit (110) comprising a coil (112) and a first switch (111), wherein a first end of the first switch (111) is connected to an input (101) and a second end of the first switch (111) is connected to the coil (112);
a first power supply unit (120, 210) comprising a second switch (121) and a voltage stabilizing diode (122), wherein the second switch (121) is connected in parallel with the voltage stabilizing diode (122), and the first power supply unit (120, 210) is connected in series with the coil unit (110), wherein a cathode of the voltage stabilizing diode (122) is connected to an output (123) of the first power supply unit (120, 210);
a current detection unit (130), which is configured to detect a current flowing through the coil (112) and to feed a current detection signal to a control unit (150);
**characterized in that** the contactor (100) further comprises:
a voltage detection unit (140), which is configured to detect a first supply voltage (Vcc1) at the output (123) and to feed a voltage detection signal to the control unit (150); and
the control unit (150), which is configured to control a duty cycle of the switching on and off of the first switch (111) according to the current detection signal by means of pulse width modulation, and to control a duty cycle of the switching on and off of the second switch (121) according to the voltage detection signal by means of pulse width modulation,
wherein the first supply voltage (Vcc1) is less than an input voltage (Vin) at the input (101).

2. The contactor (100) according to claim 1, **characterized in that** the contactor (100) further comprises: a freewheeling diode (160), wherein the freewheeling diode (160) is connected in parallel with a series circuit comprising the coil (112) and the first power supply unit (120, 210).

3. The contactor (100) according to claim 1, **characterized in that** the first power supply unit (120, 210) further comprises:
a transient voltage suppressor (211), wherein a first end of the transient voltage suppressor (211) is connected to an output (123) of the first power supply unit (120, 210), and
a second end of the transient voltage suppressor (211) is connected between the coil (112) and the first power supply unit (120, 210).

4. The contactor (100) according to claim 1, **characterized in that** the contactor (100) further comprises:
a second power supply unit (310), which is configured to convert the input voltage (Vin) at the input (101) to a second supply voltage (Vcc2);
wherein the second supply voltage (Vcc2) is output by the second power supply unit (310) in response to the input voltage (Vin) being less than a voltage threshold, and the first supply voltage (Vcc1) is output by the first power supply unit (120, 210) in response to the input voltage (Vin) being greater than the voltage threshold.

5. The contactor (100) according to claim 4, **characterized in that** the voltage threshold is 400V.

6. The contactor (100) according to claim 1, **characterized in that** the first switch (111) and/or the second switch (121) are constructed as insulated gate bipolar transistors.

7. The contactor (100) according to claim 1, **characterized in that** the current detection unit (130) comprises a sampling resistor and a filter circuit connected in parallel with the sampling resistor.

8. The contactor (100) according to claim 1, **characterized in that** the contactor (100) further comprises: a rectifier module (410), which is configured to convert the alternating current at the input (101) to direct current.

9. The contactor (100) according to claim 1, **characterized in that** the first supply voltage (Vcc1) is 15 V.

## Patentansprüche

1. Schütz (100), umfassend:
eine Spuleneinheit (110), die eine Spule (112) und einen ersten Schalter (111) umfasst, wobei ein erstes Ende des ersten Schalters (111) mit einem Eingang (101) verbunden ist und ein zweites Ende des ersten Schalters (111) mit der Spule (112) verbunden ist;
eine erste Stromversorgungseinheit (120, 210), die einen zweiten Schalter (121) und eine Spannungsstabilisierungsdiode (122) umfasst, wobei der zweite Schalter (121) parallel zu der Spannungsstabilisierungsdiode (122) geschaltet ist und die erste Stromversorgungseinheit (120, 210) in Reihe mit der Spuleneinheit (110) geschaltet ist, wobei eine Kathode der Spannungsstabilisierungsdiode (122) mit einem Ausgang (123) der ersten Stromversorgungseinheit (120, 210) verbunden ist; eine Stromerfassungseinheit (130), die eingerichtet ist, einen durch die Spule (112) fließenden Strom zu erfassen und ein Stromerfassungssignal einer Steuereinheit (150) zuzuführen;
**dadurch gekennzeichnet, dass** der Schütz (100) ferner umfasst:
eine Spannungserfassungseinheit (140), die eingerichtet ist, eine erste Versorgungsspannung (Vcc1) an dem Ausgang (123) zu erfassen und ein Spannungserfassungssignal der Steuereinheit (150) zuzuführen; und
die Steuereinheit (150), die eingerichtet ist, ein Tastverhältnis des Ein- und Ausschaltens des ersten Schalters (111) gemäß dem Stromerfassungssignal mittels Pulsweitenmodulation zu steuern und ein Tastverhältnis des Ein- und Ausschaltens des zweiten Schalters (121) gemäß dem Spannungserfassungssignal mittels Pulsweitenmodulation zu steuern,
wobei die erste Versorgungsspannung (Vcc1) kleiner als eine Eingangsspannung (Vin) an dem Eingang (101) ist.

2. Schütz (100) nach Anspruch 1, **dadurch gekennzeichnet, dass** der Schütz (100) ferner umfasst: eine Freilaufdiode (160), wobei die Freilaufdiode (160) parallel zu einer Reihenschaltung geschaltet ist, die die Spule (112) und die erste Stromversorgungseinheit (120, 210) umfasst.

3. Schütz (100) nach Anspruch 1, **dadurch gekennzeichnet, dass** die erste Stromversorgungseinheit (120, 210) ferner umfasst:
einen Transientenspannungsunterdrücker (211), wobei ein erstes Ende des Transientenspannungsunterdrückers (211) mit einem Ausgang (123) der ersten Stromversorgungseinheit (120, 210) verbunden ist, und
ein zweites Ende des Transientenspannungsunterdrückers (211) zwischen der Spule (112) und der ersten Stromversorgungseinheit (120, 210) angeschlossen ist.

4. Schütz (100) nach Anspruch 1, **dadurch gekennzeichnet, dass** der Schütz (100) ferner umfasst:
eine zweite Stromversorgungseinheit (310), die eingerichtet ist, die Eingangsspannung (Vin) an dem Eingang (101) in eine zweite Versorgungsspannung (Vcc2) umzuwandeln;
wobei die zweite Versorgungsspannung (Vcc2) durch die zweite Stromversorgungseinheit (310) als Reaktion darauf ausgegeben wird, dass die Eingangsspannung (Vin) kleiner als ein Spannungsschwellenwert ist, und die erste Versorgungsspannung (Vcc1) durch die erste Stromversorgungseinheit (120, 210) als Reaktion darauf ausgegeben wird, dass die Eingangsspannung (Vin) größer als der Spannungsschwellenwert ist.

5. Schütz (100) nach Anspruch 4, **dadurch gekennzeichnet, dass** der Spannungsschwellenwert 400V beträgt.

6. Schütz (100) nach Anspruch 1, **dadurch gekennzeichnet, dass** der erste Schalter (111) und/oder der zweite Schalter (121) als Bipolartransistoren mit isoliertem Gate ausgebildet sind.

7. Schütz (100) nach Anspruch 1, **dadurch gekennzeichnet, dass** die Stromerfassungseinheit (130) einen Abtastwiderstand und eine parallel zu dem Abtastwiderstand geschaltete Filterschaltung umfasst.

8. Schütz (100) nach Anspruch 1, **dadurch gekennzeichnet, dass** der Schütz (100) ferner umfasst:
ein Gleichrichtermodul (410), das eingerichtet ist, den Wechselstrom an dem Eingang (101) in Gleichstrom umzuwandeln.

9. Schütz (100) nach Anspruch 1, **dadurch gekennzeichnet, dass** die erste Versorgungsspannung (Vcc1) 15 V beträgt.

## Revendications

1. Contacteur (100), comprenant :
une unité de bobine (110) comprenant une bobine (112) et un premier interrupteur (111), dans laquelle une première extrémité du premier interrupteur (111) est connectée à une entrée (101),et une seconde extrémité du premier interrupteur (111) est connectée à la bobine (112) ;
une première unité d'alimentation électrique (120, 210) comprenant un deuxième interrupteur (121) et une diode de stabilisation de tension (122), le deuxième interrupteur (121) étant connecté en parallèle à la diode de stabilisation de tension (122), et la première unité d'alimentation électrique (120, 210) étant connectée en série avec l'unité de bobine (110 une cathode de la diode de stabilisation de tension (122) étant connectée à une sortie (123) de la première unité d'alimentation électrique (120, 210) ;
une unité de détection de courant (130), qui est configurée pour détecter un courant s'écoulant à travers la bobine (112) et fournir un signal de détection de courant à une unité de commande (150) ;
**caractérisé en ce que** le contacteur (100) comprend en outre :
une unité de détection de tension (140), qui est configurée pour détecter une première tension d'alimentation (Vcc1) à la sortie (123) et fournir un signal de détection de tension à l'unité de commande (150) ; et
l'unité de commande (150), qui est configurée pour commander un rapport cyclique de la mise en marche et de l'arrêt du premier interrupteur (111) selon le signal de détection de courant au moyen d'une modulation de largeur d'impulsion, et pour commander un rapport cyclique de la mise en marche et de l'arrêt du deuxième interrupteur (121) selon le signal de détection de tension au moyen d'une modulation de largeur d'impulsion,
dans lequel la première tension d'alimentation (Vcc1) est inférieure à une tension d'entrée (Vin) à l'entrée (101).

2. Contacteur (100) selon la revendication 1, **caractérisé en ce que** le contacteur (100) comprend en outre : une diode de roue libre (160), dans lequel la diode de roue libre (160) est connectée en parallèle à un circuit en série comprenant la bobine (112) et la première unité d'alimentation électrique (120, 210).

3. Contacteur (100) selon la revendication 1, **caractérisé en ce que** la première unité d'alimentation électrique (120, 210) comprend en outre :
un suppresseur de tension transitoire (211), dans lequel une première extrémité du suppresseur de tension transitoire (211) est connectée à une sortie (123) de la première unité d'alimentation électrique (120, 210), et
une seconde extrémité du suppresseur de tension transitoire (211) est connectée entre la bobine (112) et la première unité d'alimentation électrique (120, 210).

4. Contacteur (100) selon la revendication 1, **caractérisé en ce que** le contacteur (100) comprend en outre :
une deuxième unité d'alimentation électrique (310), qui est configurée pour convertir la tension d'entrée (Vin) à l'entrée (101) en une deuxième tension d'alimentation (Vcc2) ;
dans lequel la deuxième tension d'alimentation (Vcc2) est délivrée par la deuxième unité d'alimentation électrique (310) en réponse au fait que la tension d'entrée (Vin) est inférieure à un seuil de tension, et la première tension d'alimentation (Vcc1) est délivrée par la première unité d'alimentation électrique (120, 210) en réponse au fait que la tension d'entrée (Vin) est supérieure au seuil de tension.

5. Contacteur (100) selon la revendication 4, **caractérisé en ce que** le seuil de tension est de 400 V.

6. Contacteur (100) selon la revendication 1, **caractérisé en ce que** le premier interrupteur (111) et/ou le deuxième interrupteur (121) sont conçus comme transistors bipolaires à grille isolée.

7. Contacteur (100) selon la revendication 1, **caractérisé en ce que** l'unité de détection de courant (130) comprend une résistance d'échantillonnage et un circuit de filtrage connecté en parallèle à la résistance d'échantillonnage.

8. Contacteur (100) selon la revendication 1, **caractérisé en ce que** le contacteur (100) comprend en outre :
un module redresseur (410), qui est configuré pour convertir le courant alternatif à l'entrée (101) en courant continu.

9. Contacteur (100) selon la revendication 1, **caractérisé en ce que** la première tension d'alimentation (Vcc1) est de 15 V.
